(19) Europäisches Patentamt
European Patent Office
Office européen des brevets

(11) **EP 2 504 695 B1**

(12) **EUROPÄISCHE PATENTSCHRIFT**

(45) Veröffentlichungstag und Bekanntmachung des Hinweises auf die Patenterteilung:
**02.10.2013 Patentblatt 2013/40**

(21) Anmeldenummer: **10784301.3**

(22) Anmeldetag: **25.11.2010**

(51) Int Cl.:
*G01N 30/66* (2006.01)     *G01N 25/48* (2006.01)
*G01N 27/18* (2006.01)     *G01N 33/00* (2006.01)

(86) Internationale Anmeldenummer:
**PCT/EP2010/068238**

(87) Internationale Veröffentlichungsnummer:
**WO 2011/064310 (03.06.2011 Gazette 2011/22)**

(54) **VERFAHREN UND ANORDNUNG ZUR GASCHROMATOGRAPHISCHEN ANALYSE EINER GASPROBE**

METHOD AND ARRANGEMENT FOR GAS CHROMATOGRAPHIC ANALYSIS OF A GAS SAMPLE

PROCÉDÉ ET AGENCEMENT POUR L'ANALYSE PAR CHROMATOGRAPHIE GAZEUSE D'UN ÉCHANTILLON DE GAZ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **25.11.2009 DE 102009055785**
**05.07.2010 DE 102010026078**

(43) Veröffentlichungstag der Anmeldung:
**03.10.2012 Patentblatt 2012/40**

(73) Patentinhaber: **Siemens Aktiengesellschaft 80333 München (DE)**

(72) Erfinder:
• **GELLERT, Udo 76756 Bellheim (DE)**
• **PROBST, Frank 76863 Herxheim bei Landau/Pfalz (DE)**

(56) Entgegenhaltungen:
WO-A1-2009/095494      WO-A2-02/50530
DE-A1-102009 014 618     JP-A- 61 226 659
US-A- 3 628 003          US-A- 5 883 310
US-A1- 2004 144 169      US-A1- 2007 209 433
US-A1- 2009 141 767

• **RATH H J; WIMMER J: "Gas Chromatographic Analysis of traces of Hydrogen Sulfide in Hydrogen", CHROMATOGRAPHIA, Bd. 13, Nr. 8, August 1980 (1980-08), Seiten 513-514, XP002621719, FRIEDR. VIEWEG & SOHN**
• **FARMER B ET AL: "Options in gas chromatographic techniques for measurement of H2S in fuel gas", 54TH ANALYSIS DIVISION SYMPOSIUM 2009 : HOUSTON, TEXAS, USA, 19 - 23 APRIL 2009, CURRAN, RED HOOK, US, Bd. 478, 1. Januar 2009 (2009-01-01), Seiten 73-92, XP009144338, ISBN: 978-1-61567-193-9**

**Beschreibung**

Die Erfindung betrifft ein Verfahren zur gaschromatographischen Analyse einer Gasprobe, die mittels eines Trägergases durch eine Trenneinrichtung mit nachgeordnetem Wärmeleitfähigkeitsdetektor geleitet wird, der als Messsignal ein Chromatogramm mit Peaks für unterschiedliche Analyten liefert.

Die Erfindung betrifft ferner eine entsprechende Anordnung zur gaschromatographischen Analyse einer Gasprobe.

In der Chromatographie wird eine Probe eines zu analysierenden Stoffgemischs mittels eines Trägergases durch eine chromatographische Trenneinrichtung geleitet. Aufgrund unterschiedlicher Wanderungsgeschwindigkeiten durch die Trenneinrichtung erreichen die Analyten, also die einzelnen Stoffe des Stoffgemischs, den Ausgang der Trenneinrichtung zu unterschiedlichen Zeitpunkten und werden dort nacheinander mittels eines geeigneten Detektors detektiert. Der Detektor erzeugt als Messsignal ein Chromatogramm, das aus einer Basislinie und einer den getrennten Stoffen entsprechenden Anzahl von Peaks besteht. In der Praxis ist das Chromatogramm verrauscht, wobei die einzelnen Peaks mehr oder weniger deutlich aus dem Signalrauschen herausragen. Bei gut aufgelösten Peaks ist die Peakfläche über der rauschfreien Basislinie zur Konzentration des Analyten proportional, wobei die Peakfläche im Gegensatz zur Peakhöhe auch bei unsymmetrischen Peaks genaue Ergebnisse liefert.

In der Gaschromatographie werden bevorzugt Wärmeleitfähigkeitsdetektoren zum Nachweis der getrennten Analyten anhand ihrer stofftypischen Wärmeleitfähigkeit verwendet. Dazu werden, wie beispielsweise die EP 1381854 B1 zeigt, die getrennten Analyten nacheinander in einem Kanal an einem dort angeordneten und elektrisch beheizten Heizfaden vorbeigeführt, wobei je nach Wärmeleitfähigkeit des vorbeiströmenden Analyten im Vergleich zu der des Trägergases mehr oder weniger Wärme von dem Heizfaden auf die Kanalwandung abgeleitet wird und sich dementsprechend der Heizfaden mehr oder weniger abkühlt oder erwärmt. Dadurch ändert sich der elektrische Widerstand des Heizfadens, was detektiert wird. Dazu ist der Heizfaden üblicherweise in einer Messbrücke angeordnet, die einen weiteren Heizfaden in einem von einem Referenzgas durchströmten weiteren Kanal enthält.

Die Detektionsempfindlichkeit des Wärmeleitfähigkeitsdetektors ist umso größer je größer die Temperaturdifferenz zwischen dem Heizfaden und der Kanalwandung ist, wobei hohe Temperaturen die Standzeit des Heizfadens beeinträchtigen. Die Empfindlichkeit hängt auch von dem spezifischen elektrischen Widerstand des Heizfadens ab, weil dadurch bei vorgegebener Geometrie des Heizfadens dessen Gesamtwiderstand gegeben ist. Je größer dieser Gesamtwiderstand ist, umso größer ist auch die Detektionsempfindlichkeit. Schließlich können chemisch aggressive Gase den Heizfaden angreifen und zersetzen.

Bei dem aus der EP 1381854 B1 bekannten Wärmeleitfähigkeitsdetektor besteht der Heizfaden aus Gold und/oder Platin. Der mit Gold realisierbare Heizfadenwiderstand ist mit ca. 15 bis 25 Ω niedrig und begrenzt die Detektionsempfindlichkeit. Um einen Heizfadenwiderstand von typischerweise 20 Ω zu erreichen muss der Goldfaden in seinen Abmessungen sehr dünn (< 0,3 $\mu$m) und schmal (typ. 6 $\mu$m) bei einer Länge von 1 mm realisiert werden. Solch filigrane Abmessungen führen zu einer sehr kleinen Wärmekapazität und damit einer sehr kurzen Ansprechzeit, aber auch zu einer geringen Robustheit. Nicht zuletzt können schwefelwasserstoffhaltige Gase den Goldfaden zerstören. Platin hat eine sehr viel höhere Schmelztemperatur als Gold und den fünffachen spezifischen Widerstand bei fast gleichem Temperaturkoeffizienten des elektrischen Widerstands. Der Vorteil von Platin ist seine chemische Inertheit, wodurch sich allerdings die Herstellung in Dünnfilmtechnologie als sehr schwierig erweist. Ein weiterer Nachteil ist die katalytische Wirkung von Platin in Gasgemischen, die Wasserstoff und Kohlenwasserstoffe enthalten.

Aus der DE 39 06 405 A1 ist ein Wärmeleitfähigkeitsdetektor für Gasanalysatoren bekannt, bei dem das Heizelement kein freiliegender Heizfaden sondern eine auf einer Trägerplatte ausgebildete Widerstandsschicht ist. Zum Schutz gegenüber aggressiven Gasen ist die Widerstandsschicht mit einer PECVD-Schicht überzogen.

Aus der WO 2007/106689 A2, WO 2008/098820 A1 und E. Meng und Y.-C. Tai: "A Parylene MEMS Flow Sensing Array" in Transducers 2003, 2003, Boston, MA, ist jeweils ein thermischer Massendurchflusssensor bekannt, bei dem freiliegende Heiz- und/oder Sensorelemente mit einer Schutzschicht aus Parylene versehen sind.

Parylene ist ein Sammelbegriff für polymere Beschichtungsmaterialien, von denen insbesondere die Parylene-Arten Parylene N (Poly- para- Xylylen), Parylene C (Chloro- poly- para- Xylylen), Parylene D (Di- chloro- poly- para-Xylylen) und Parylene F (Poly (Tetrafluoro- para- Xylylen) ) industriell zum Einsatz kommen. Der Schmelzpunkt von Parylene N liegt mit 410 °C zwar sehr hoch, allerdings ändern sich die mechanischen Eigenschaften bei steigender Temperatur. Die Temperaturstabilität ist, insbesondere in Sauerstoff- Umgebung, von allen Parylene- Arten am geringsten. Parylene C weist zwar sehr gute Barriere- Eigenschaften, d. h. sehr geringe Gasdurchlässigkeiten auf jedoch ist der Schmelzpunkt mit 290 °C der niedrigste der hier genannten Parylene- Arten. Parylene D besitzt eine relativ hohe thermische Stabilität bis zu 380 °C. Die mechanischen und elektrischen Eigenschaften bleiben bei einer Temperaturerhöhung im Vergleich zu Parylene N und Parylene C am besten erhalten. Der Schmelzpunkt von Parylene F liegt mit über 500 °C weit über den anderen drei Parylene- Arten. Parylene F weist mit über 500 °C den höchsten Schmelzpunkt gegenüber den anderen drei Parylene- Arten und auch die höchste Temperaturstabilität auf. Das Parylene F ist dem Parylene N chemisch sehr ähnlich, so dass die Gaspermeabilität bei beiden in etwa gleich ist, d. h. durchlässig für Sauerstoff und in sehr hohem Maße auch durchlässig für Schwefelwasserstoff.

Der Erfindung liegt die Aufgabe zugrunde, ein Verfahren zur gaschromatographischen Analyse einer Gasprobe unter Verwendung eines Wärmeleitfähigkeitsdetektors mit einem parylenebeschichteten Goldfaden und unter Berücksichtigung der Eigenschaften von Parylene anzugeben.

Gemäß der Erfindung wird die Aufgabe dadurch gelöst, dass bei dem Verfahren der eingangs angegebenen Art Wasserstoff als Trägergas und ein Wärmeleitfähigkeitsdetektor mit einem elektrisch beheizten und mit Parylene F beschichteten Goldfaden verwendet wird und dass durch Differenzieren des Chromatogramms an der Stelle des Analyten Schwefelwasserstoff ein Peak für diesen Analyten erzeugt wird.

Aus bisherigen Beobachtungen an Wärmeleitfähigkeitsdetektoren mit unbeschichtetem Goldfaden hat sich ergeben, dass der aufgeheizte Goldfaden an seiner Oberfläche durch Schwefelwasserstoff konditioniert, also verändert wird. Dadurch ändert sich insbesondere bei einem sehr dünnen und schmalen Goldfaden dessen elektrischer Widerstand. Die Veränderung an dem Goldfaden ist reversibel und wird in einer Sauerstoff- oder Wasserstoffumgebung wieder rückgängig gemacht. Wärmeleitfähigkeitsdetektoren mit Goldfaden wurden bisher in der Gaschromatographie nicht verwendet, wenn Schwefelwasserstoff nachzuweisen war. Dasselbe gilt auch für den Nachweis von Sauerstoff in Gegenwart von Wasserstoff als Trägergas, weil die wechselnde Oxidation an der Oberfläche des Goldfadens durch den Sauerstoff und Reduktion durch den Wasserstoff zu einem Drift der Basislinie in dem Chromatogramm führt. Parylene F, ist für die meisten Moleküle, so z. B. auch für Sauerstoff, undurchlässig. Für einige Moleküle, wie Helium, Wasserstoff und Schwefelwasserstoff, ist dieses Parylene jedoch durchlässig. Ein Abbau der durch Schwefelwasserstoff verursachten Konditionierung des aufgeheizten Goldfadens durch Sauerstoff ist daher nicht möglich, wohl aber durch Wasserstoff. Es hat sich aber gezeigt, dass das von dem Wärmeleitfähigkeitsdetektor beim Auftreten des Analyten Schwefelwasserstoff gelieferte Messsignal im Wesentlichen von der elektrischen Widerstandsänderung als Folge der der durch Schwefelwasserstoff verursachten Konditionierung des aufgeheizten Goldfadens abhängt und nicht oder nur kaum von dem Unterschied zwischen der Wärmeleitfähigkeit von Schwefelwasserstoff und der von Wasserstoff beeinflusst ist. Das unmittelbar erhaltene Messsignal für Schwefelwasserstoff bildet also die Integralkurve eines Peaks, weswegen das Chromatogramm an der Stelle des Analyten Schwefelwasserstoff durch Bildung der ersten Ableitung differenziert und damit ein Peak für diesen Analyten erzeugt wird. Bei den unmittelbar auf den Schwefelwasserstoff folgenden Analyten ist die Basislinie des Chromatogramms so lange erhöht, bis die durch den Schwefelwasserstoff verursachte Konditionierung des Goldfadens durch den Wasserstoff wieder abgebaut ist. Die Auswertung der Peaks, z. B. Bestimmung der Peakfläche, erfolgt jedoch von der Basislinie aus, so dass deren Höhe die Messung nicht beeinträchtigt.

Schließlich erlaubt der Wärmeleitfähigkeitsdetektor mit dem parylene-beschichtetem Goldfaden wegen der Undurchlässigkeit von Parylene für Sauerstoff die uneingeschränkte Verwendung von Wasserstoff als Trägergas, also auch bei dem Analyten Sauerstoff.

Die Realisierung der Differenzierung des Chromatogramms durch entsprechende Änderung oder Ergänzung bestehender Auswertungs-Software ist bei Prozesschromatographen mit erheblichem zeitlichem und finanziellem Entwicklungsaufwand verbunden. Um diesen Aufwand auf in Mindestmaß zu verringern, kann in vorteilhafter Weise das Messsignal mittels eines RC-Glieds differenziert werden, welches gebildet wird, indem der Wärmeleitfähigkeitsdetektor über mindestens einen Kondensator mit einem Eingang einer Auswerteeinrichtung verbunden wird.

Gegenstand der Erfindung ist somit auch eine Anordnung zur gaschromatographischen Analyse einer Gasprobe, mit einer Trenneinrichtung und einem ihr nachgeordneten Wärmeleitfähigkeitsdetektor, durch die die Gasprobe mittels eines aus Wasserstoff bestehenden Trägergases geleitet wird, wobei der Wärmeleitfähigkeitsdetektor als Messsignal ein Chromatogramm mit Peaks für unterschiedliche Analyten liefert, wobei ferner der Wärmeleitfähigkeitsdetektor einen elektrisch beheizten und mit Parylene F beschichteten Goldfaden aufweist und zur Realisierung eines das Messsignal an der Stelle des Analyten Schwefelwasserstoff differenzierenden und einen Peak für diesen Analyten erzeugenden RC-Glieds über mindestens einen Kondensator mit einem Eingang einer Auswerteeinrichtung verbunden ist.

Bei einer über mindestens zwei Eingänge verfügenden Auswerteeinrichtung wird das Messsignal dem einen Eingang differenziert und dem anderen Eingang unverändert zugeführt.

Die Hardware-Realisierung der Differenzierung des Chromatogramms kommt mit nur einem Kondensator oder jeweils einem Kondensator für jeden der beiden Eingangszweige aus und ist somit äußerst aufwandsarm.

Zur weiteren Erläuterung der Erfindung wird im Folgenden auf die Figuren der Zeichnung Bezug genommen; im Einzelnen zeigen:

Figur 1      ein vereinfachtes Beispiel für einen Gaschromatographen,

Figur 2      ein vereinfachtes Beispiel für das erhaltene und bearbeitete Chromatogramm und

Figur 3      ein Beispiel für die Hardware-Realisierung der Differenzierung des Chromatogramms.

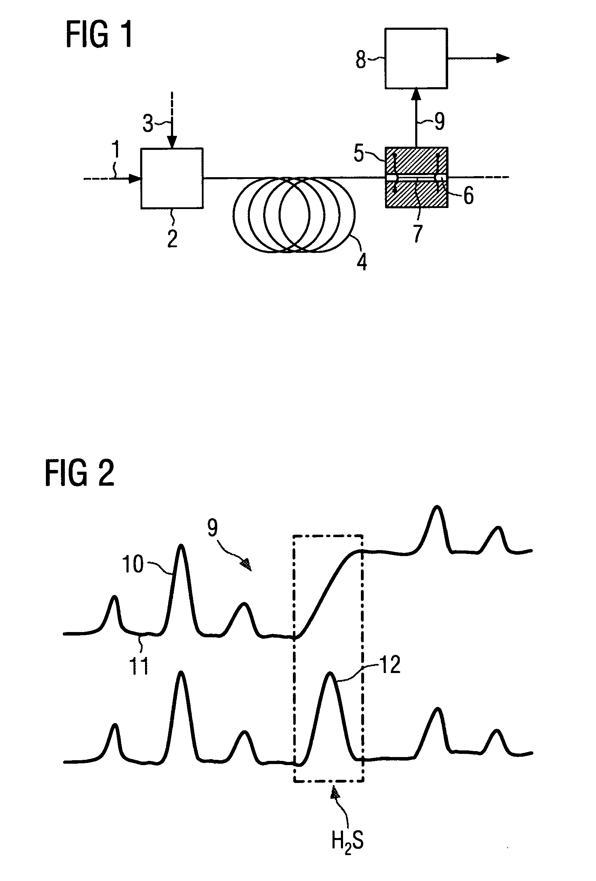

Figur 1 zeigt einen Gaschromatograph bei dem Wasserstoff als Trägergas 1 einem Injektor 2 zugeführt wird, dort mit einer Probe 3 eines zu analysierenden Stoffgemisches beladen wird und anschließend in eine Trenneinrichtung 4 in Form einer Trennkapillare oder Schaltung von Trennkapillaren eingeleitet wird. Die aus der Trenneinrichtung 4 nacheinander austretenden getrennten Probenkomponenten (Analyten) gelangen zu einem Wärmeleitfähigkeitsdetektor 5. Dort werden die getrennten Analyten in einem Kanal 6 an einem dort angeordneten und elektrisch beheizten Heizfaden 7 vorbeigeführt, der aus Gold besteht und ebenso wie die Kanalwandung mit Parylene F beschichtet ist. Je nach Wärmeleitfähigkeit des jeweils vorbeiströmenden Analyten im Vergleich zu der des Trägergases wird mehr oder weniger Wärme von dem Heizfaden 7 auf die Kanalwandung abgeleitet, so dass sich der Heizfaden 7 dementsprechend abkühlt oder erwärmt. Als Folge davon ändert sich der elektrische Widerstand des Heizfadens 7, was in einer Auswerteeinrichtung 8 detektiert wird. Dazu ist der Heizfaden üblicherweise in einer hier nicht gezeigten Messbrücke angeordnet, die einen weiteren Heizfaden in einem von einem Referenzgas, z. B. dem Trägergas 1, durchströmten weiteren Kanal aufweist.

Der Wärmeleitfähigkeitsdetektor 5 liefert als Messsignal 9 ein im oberen Teil der Figur 2 in sehr vereinfachter Darstellung gezeigtes Chromatogramm mit Peaks für unterschiedliche Analyten. Das Chromatogramm 9 wird in der Auswerteeinrichtung 8 digitalisiert in der Weise ausgewertet, dass die von den unterschiedlichen Analyten hervorgerufenen Peaks, z. B. 10, in dem üblicherweise vorhandenen Signalrauschen identifiziert und ihre der Konzentration des Analyten entsprechende Fläche über der Basislinie 11 bestimmt wird.

Da Parylene F für Schwefelwasserstoff ($H_2S$) durchlässig ist, wird der beheizte Goldfaden 7 des Wärmeleitfähigkeitsdetektors 5 beim Auftreten dieses Analyten in einer Weise konditioniert, dass sich der elektrische Widerstand erhöht. Dieser Effekt ist so groß, dass er die eigentliche Wärmeleitfähigkeitsmessung überdeckt. Die Konditionierung des Goldfadens 7 wird anschließend durch das Trägergas Wasserstoff wieder abgebaut. Das Chromatogramm 9 weist daher an der Stelle des Analyten Schwefelwasserstoff einen sprungartigen Verlauf auf, wobei die Sprunghöhe von der Konzentration des Schwefelwasserstoffs abhängig ist.

Wie im unteren Teil der Figur 2 zu sehen ist, wird das Chromatogramm 9 im Bereich des Analyten Schwefelwasserstoff durch Bildung der ersten Ableitung differenziert, wodurch ein Peak 12 für diesen Analyten erzeugt wird. Dieser Bereich ist so groß gewählt, dass für die Auswertung des Peaks 12 ausreichend Basislinie 11' vor und hinter dem Peak 12 generiert wird. Bei den unmittelbar auf den Schwefelwasserstoff folgenden Analyten ist die Basislinie 11 des Chromatogramms 9 so lange erhöht (Offset), bis die durch den Schwefelwasserstoff verursachte Konditionierung des Goldfadens 7 durch den Wasserstoff wieder abgebaut ist. Die Auswertung der Peaks, z. B. Bestimmung der Peakfläche, erfolgt jedoch von der Basislinie 11 aus, so dass deren Höhe die Messung nicht beeinträchtigt. Im unteren Teil der Figur 2 ist der Offset der Basislinie 11 aus dem Chromatogramm 9 herausgerechnet, d. h. die auf den durch Differenzierung erzeugten Peak 12 folgenden Peaks werden auf das Basislinien-Niveau 11' des Peaks 12 heruntergezogen.

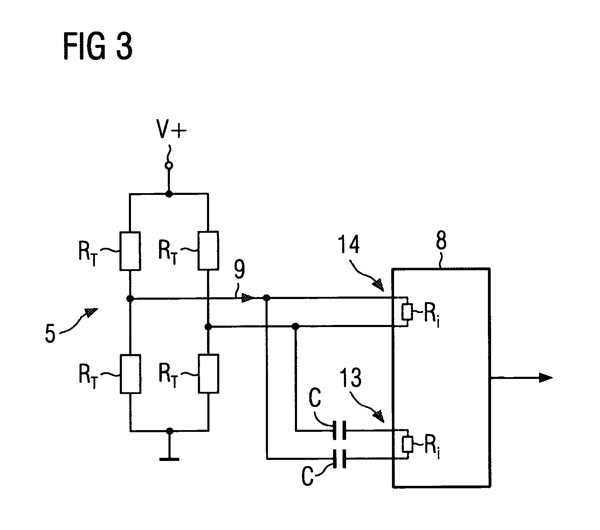

Figur 3 zeigt ein Schaltbild des Wärmeleitfähigkeitsdetektors 5 mit vier Widerständen $R_T$, die in einer Brückenschaltung angeordnet sind. Jeder Widerstand $R_T$, entspricht einem Goldfaden 7 (Figur 1), wobei zwei in der Brückenschaltung diagonal gegenüberliegende Goldfäden 7 von der chromatographisch getrennten Probe 3 und die beiden anderen Goldfäden 7 von dem Trägergas 1 umströmt werden. Die Auswerteeinrichtung 8 ist zwei- oder mehrkanalig und verfügt dementsprechend über mindestens zwei analoge Eingänge 13 und 14. Das Messsignal 9 des Wärmeleitfähigkeitsdetektors 5 wird dem Eingang 14 unverändert und dem Eingang 13 differenziert zugeführt. Dazu ist in jedem der beiden Eingangszweige des Eingangs 13 jeweils ein Kondensator C eingefügt, der mit dem Eingangswiderstand $R_i$ ein differenzierendes RC-Glied bildet.

Es seien $f_u$ die kleinste Frequenz und $f_o$ die größte Frequenz im betrachteten Messsignalverlauf. Dann ergibt sich C in der Bandbreite zwischen:

$$1/[2\pi f_o \cdot (R_i + R_T)] \; < \; C \; < \; 1/[2\pi f_u \cdot (R_i + R_T)],$$

also beispielsweise 32 μF < C < 160 μF für $f_u$ = 0,1 Hz, $f_o$ = 5 Hz und $R_i + R_T \approx$ 1000 Ω.

## Patentansprüche

1. Verfahren zur gaschromatographischen Analyse einer Gasprobe, die mittels eines Trägergases (1) durch eine Trenneinrichtung (4) mit nachgeordnetem Wärmeleitfähigkeitsdetektor (5) geleitet wird, der als Messsignal (9) ein Chromatogramm mit Peaks für unterschiedliche Analyten liefert, wobei Wasserstoff als Trägergas (1) und ein Wärmeleitfähigkeitsdetektor (5) mit einem elektrisch beheizten und mit Parylene F beschichteten Goldfaden (7) verwendet wird und wobei durch Differenzieren des Chromatogramms an der Stelle des Analyten Schwefelwasserstoff ein Peak für diesen Analyten erzeugt wird.

**2.** Verfahren nach Anspruch 1, **dadurch gekennzeichnet, dass** das Messsignal (9) mittels eines RC-Glieds differenziert wird, welches gebildet wird, indem der Wärmeleitfähigkeitsdetektor (5) über mindestens einen Kondensator (C) mit einem Eingang (13) einer Auswerteeinrichtung (8) verbunden wird.

**3.** Verfahren nach Anspruch 1 oder 2, **dadurch gekennzeichnet, dass** der Analyt Sauerstoff in dem Trägergas (1) Wasserstoff nachgewiesen wird.

**4.** Anordnung zur gaschromatographischen Analyse einer Gasprobe, mit einer Trenneinrichtung (4) und einem ihr nachgeordneten Wärmeleitfähigkeitsdetektor (5), durch die die Gasprobe mittels eines aus Wasserstoff bestehenden Trägergases (1) geleitet wird, wobei der Wärmeleitfähigkeitsdetektor (5) als Messsignal (9) ein Chromatogramm mit Peaks für unterschiedliche Analyten liefert, wobei ferner der Wärmeleitfähigkeitsdetektor (5) einen elektrisch beheizten und mit Parylene F beschichteten Goldfaden (7) aufweist und zur Realisierung eines das Messsignal (9) an der Stelle des Analyten Schwefelwasserstoff differenzierenden und einen Peak für diesen Analyten erzeugenden RC-Glieds über mindestens einen Kondensator (C) mit einem Eingang (13) einer Auswerteeinrichtung (8) verbunden ist.

**5.** Anordnung nach Anspruch 4, **dadurch gekennzeichnet, dass** die Auswerteeinrichtung (8) über mindestens zwei Eingänge (13, 14) verfügt, von denen der eine Eingang (13) das Messsignal (9) differenziert und der andere Eingang (14) unverändert erhält.

**Claims**

**1.** Method for gas chromatographic analysis of a gas sample, which is conveyed by means of a carrier gas (1) through a separating device (4) having a downstream thermal conductivity detector (5), which delivers a chromatogram having peaks for different analytes as a measurement signal (9), wherein hydrogen is used as the carrier gas (1) and a thermal conductivity detector (5) having an electrically heated gold filament (7) coated with parylene F and wherein a peak for the analyte hydrogen sulfide is generated by differentiating the chromatogram at the position of this analyte.

**2.** Method according to Claim 1, **characterized in that** the measurement signal (9) is differentiated by means of an RC component, which is formed by connecting the thermal conductivity detector (5) via at least one capacitor (C) to an input (13) of an evaluation device (8).

**3.** Method according to Claim 1 or 2, **characterized in that** the analyte oxygen is detected in the carrier gas (1) hydrogen.

**4.** Arrangement for gas chromatographic analysis of a gas sample, having a separating device (4) and a thermal conductivity detector (5) downstream thereof, through which the gas sample is conveyed by means of a carrier gas (1) consisting of hydrogen, wherein the thermal conductivity detector (5) delivers a chromatogram having peaks for different analytes as a measurement signal (9), wherein furthermore the thermal conductivity detector (5) has an electrically heated gold filament (7) coated with parylene F and is connected via at least one capacitor (C) to an input (13) of an evaluation device (8) in order to realize an RC component which differentiates the measurement signal (9) at the position of the analyte hydrogen sulfide and generates a peak for this analyte.

**5.** Arrangement according to Claim 4, **characterized in that** the evaluation device (8) comprises at least two inputs (13, 14), of which one input (13) receives the measurement signal (9) differentiated and the other input (14) receives it unmodified.

**Revendications**

**1.** Procédé d'analyse par chromatographie en phase gazeuse d'un échantillon de gaz que l'on fait passer au moyen d'un gaz (1) porteur dans un dispositif (4) de séparation ayant un détecteur (5) de conductibilité de la chaleur, qui est monté en aval et qui fournit comme signal (9) de mesure un chromatogramme ayant des pics pour des analytes différents, dans lequel on utilise de l'hydrogène comme gaz (1) porteur et un détecteur (5) de conductibilité de la chaleur ayant un fil (7) d'or chauffé électriquement et revêtu de parylène F et dans lequel on produit, par différentiation du chromatogramme à la place de l'analyte hydrogène sulfuré, un pic pour cet analyte.

**2.** Procédé suivant la revendication 1,
**caractérisé en ce que** l'on différentie le signal (9) de mesure au moyen d'un élément RC, qui est formé en reliant le détecteur (5) de conductibilité de la chaleur à une entrée (13) d'un dispositif (8) d'exploitation par au moins un condensateur (C).

**3.** Procédé suivant l'une des revendications 1 ou 2, **caractérisé en ce qu'**on décèle l'analyte oxygène dans l'hydrogène servant de gaz (1) porteur.

**4.** Dispositif d'analyse par chromatographie en phase gazeuse d'un échantillon de gaz, comprenant un dispositif (4) de séparation et un détecteur (5) de conductibilité de la chaleur qui y est monté en aval et dans lequel on fait passer l'échantillon de gaz au moyen d'un gaz (1) porteur constitué d'hydrogène, dans lequel le détecteur (5) de conductibilité de la chaleur fournit comme signal (9) de mesure un chromatogramme ayant des pics pour des analytes différents, dans lequel, en outre, le détecteur (5) de conductibilité de la chaleur a un fil (7) d'or chauffé électriquement et revêtu de parylène F et est, pour la réalisation d'un élément RC différentiant le signal (9) de mesure à la place de l'analyte hydrogène sulfuré et produisant un pic pour cet analyte, relié à une entrée (13) d'un dispositif (8) d'évaluation par au moins un condensateur (C).

**5.** Dispositif suivant la revendication 4,
**caractérisé en ce que** le dispositif (8) d'exploitation dispose d'au moins deux entrées (13, 14) dont l'une (13) différentie le signal (9) de mesure et dont l'autre (14) reste inchangée.

FIG 1

FIG 2

$H_2S$

# FIG 3

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1381854 B1
- DE 3906405 A1
- WO 2007106689 A2
- WO 2008098820 A1

**In der Beschreibung aufgeführte Nicht-Patentliteratur**

- **E. MENG ; Y.-C. TAI.** A Parylene MEMS Flow Sensing Array. *Transducers 2003,* 2003